## Europäisches Patentamt

## European Patent Office

## Office européen des brevets

(19)

(11) Veröffentlichungsnummer: **0 067 902**
**A1**

(12) # EUROPÄISCHE PATENTANMELDUNG

(21) Anmeldenummer: **81104978.2**

(22) Anmeldetag: **26.06.81**

(51) Int. Cl.³: **B 32 B 27/00**
**B 29 F 1/10, B 29 D 11/00**

(43) Veröffentlichungstag der Anmeldung:
**29.12.82 Patentblatt 82/52**

(84) Benannte Vertragsstaaten:
**AT CH DE FR GB IT LI NL SE**

(71) Anmelder: **Press- und Spritzwerk Udo Ditter GmbH & Co.**
**Hausacher Strasse 21**
**D-7612 Haslach i.K.(DE)**

(72) Erfinder: **Thoma, Friedrich Xaver**
**Leimengrubweg 12**
**D-7612 Haslach i.K.(DE)**

(72) Erfinder: **Ditter, Rolf**
**Bethovenstrasse 9**
**D-7612 Haslach i.K.(DE)**

(74) Vertreter: **Thoma, Friedrich Xaver**
**Leimengrubweg 12**
**D-7612 Haslach i.k.(DE)**

(54) **Verfahren zum Auftragen von mechanisch stabilisierenden und/oder elektrisch, oder optoelektronisch leitenden Schichten auf Einzelteile aus Kunststoffen.**

(57) Das Auftragen von mechanisch stabilisierenden und/ oder elektrisch, oder optoelektronisch leitenden Schichten (2) auf Einzelteile (1) aus Kunststoffen soll mit größter Genauigkeit, Reproduzierbarkeit und hoher Beständigkeit rationell und wirtschaftlich erfolgen. Die Schichten (2) sollen nichtlösbar auf den Einzelteilen (1) angeordnet sein.

Nach dem vorliegenden Verfahren werden diese Schichten (2) zunächst auf einen Schichtkörper (3) nichtlösbar aufgetragen, der dann auf das Einzelteil (1) übertragen wird und dort vom Werkstoff des Einzelteiles (1) teilweise, oder erforderlichenfalls allseitig, insbesondere stoffschlüssig ummantelt wird. Dabei kann der Schichtkörper (2), der aus einer Kunststoffolie besteht, auf das Einzelteil (1) aufgeschweißt, oder beim Herstellen des Einzelteiles (1) spritzgießtechnisch vom Werkstoff des Einzelteiles (1) stoffschlüssig ummantelt werden.

Fig.1

Fig.3

EP 0 067 902 A1

Verfahren zum Auftragen von mechanisch stabilisierenden und/oder elektrisch, oder optoelektronisch leitenden Schichten auf Einzelteile aus Kunststoffen.

Die Erfindung bezieht sich auf ein Verfahren zum Auftragen von mechanisch stabilisierenden und/oder elektrisch, oder optoelektronisch leitenden Schichten, auf Einzelteile aus Kunststoffen; dabei sollen diese Schichten, die insbesondere aus Folien, Filmen, Fäden, Geweben, oder Leiterbahnen aus metallischen oder nichtmetallischen Werkstoffen bestehen, nichtlösbar auf den Einzelteilen aus Kunststoffen angeordnet sein.

Es ist vielfach erforderlich, Einzelteile aus Kunststoffen, wie z.B. Gehäuse, Baugruppenträger, Fassungen oder sonstige Einzelteile im Anwendungsbereich der Feinwerktechnik, der Optik, der Elektrotechnik und der Elektronik, nicht nur mechanisch hinsichtlich deren statischen und dynamischen Festigkeit zu stabilisieren und zu verbessern, sondern häufig auch mit elektrisch und/oder optoelektronisch leitenden Schichten zu versehen, zur Verbindung einzelner aktiver und/oder passiver Systeme. Dabei soll sichergestellt sein, daß derartige Schichten, nicht nur rationell und wirtschaftlich, sowie präzise herstellbar, sondern ebenso rationell und wirtschaftlich, sowie mit größmöglicher Genauigkeit auf derartige Einzelteile aus Kunststoffen aufgetragen und dort nichtlösbar angeordnet werden können.

Bei den bekanntgewordenen Verfahren zum Auftragen derartiger Schichten auf Einzelteile aus Kunststoffen, werden die Schichten nach der Herstellung der Kunststoffteile teilweise aufgeklebt, oder aufgeprägt, oder aufgespritzt, oder auggegossen, oder aufgedampft oder galvanisch aufgetragen. Vielfach sind dort zur Durchführung derartiger Arbeitsgänge relativ aufwendige Fixiereinrichtungen, Masken oder Stempelvorrichtungen zuzüglich zum Werkzeug für die Herstellung des Kunstoffeinzelteiles erforderlich.

Der Erfindung liegt die Aufgabe zugrunde, ein Verfahren zum Auftragen von Schichten der eingangsgenannten Art auf Einzelteile aus Kunststoffen zu schaffen, das nicht nur rationell und wirtschaftlich durchführbar ist, sondern bei dem auch die aufzutragenden Schichten äußerst wirtschaftlich und erforderlichenfalls äußerst genau und reproduzierbar herstellbar sind und bei dem, neben dem eigentlichen Werkzeug zur Herstellung eines entsprechenden Einzelteiles aus einem Kunststoff, zum Auftragen der eingangsgenannten Schichten keine zusätzlichen Werkzeuge oder Vorrichtungen erforderlich sind.

Diese Aufgabe wird erfindungsgemäß dadurch gelöst, daß die, auf ein Einzelteil aus einem Kunststoff aufzutragenden Schichten, insbesondere in Form von strukturierten Folien oder Filmen, von Fäden oder Geweben, von elektrischen oder optoelektronischen Leiterbahnen, oder von Lichtleiterfasern oder -bündeln, zunächst auf einen sogenannten Schichtkörper aufgetragen und dort nichtlösbar angeordnet sind, und daß der gestaltete Schichtkörper auf dem Einzelteil aus einem Kunststoff, den Erfordernissen entsprechend räumlich angeordnet, vom Werkstoff des Einzelteiles teilweise, oder erforderlichenfalls allseitig, insbesondere stoffschlüssig ummantelt ist.

Der Schichtkörper kann dort aus einer Folie aus einem Kunststoff bestehen, auf welcher die erforderlichen Schichten aufgetragen sind. Der Schichtkörper kann dabei in seinen Werkstoffeigenschaften, den Werkstoffeigenschaften des entsprechenden Einzelteiles aus einem Kunststoff entsprechen. Die vorgesehenen Schichten können auf einen Schichtkörper durch Aufprägen, Aufdrucken, Aufspritzen, Aufdampfen, Aufgalvanisieren, Aufwalzen oder Aufplatieren aufgetragen werden. Insbesondere Schichten mit besonderen mechanisch stabilisierenden und/oder elektrisch leitenden Eigenschaften können aus metallischen Werkstoffen bestehen. Dabei ist es dort vorgesehen, daß die auf einem Schichtkörper vorgesehenen Schichten, insbesondere solche aus metallischen Werkstoffen, auf dem Schichtkörper ihre endgültige Formgebung erhalten können. Beispielsweise können vorgesehene elektrische Leiterbahnen aus einer entsprechenden Schicht auf einem Schichtkörper herausgeätzt werden.

Vorteilhaft bei dem Verfahren nach der Erfindung ist nicht nur, daß für beliebige Einzelteile aus Kunststoffen, deren mechanische Festigkeitswerte mittelbar mittels stabilisierender Schichten verbessert werden sollen, und/oder welche mit elektrisch oder optoelektronisch leitenden Schichten versehen werden sollen, diese Schichten zunächst äußerst rationell und wirtschaftlich auf einen Schichtkörper aufgetragen werden können, wobei dann ein derartiger Schichtkörper mit den endgültig bemessenen und gestalteten Schichten auf ein entsprechendes Einzelteil aus einem Kunststoff, insbesondere durch thermoplastisches Schweißen aufgetragen werden kann, oder aber, daß ein fertig gestalteter Schichtkörper, zum Auftragen auf ein entsprechendes Einzelteil aus Kunststoff in das Spritzwerkzeug für die Herstellung des Einzelteiles eingelegt und durch den folgenden Spritzpressarbeitsgang vom Werkstoff des Einzelteiles teilweise oder erforderlichenfalls allseitig ummantelt wird, sondern daß auch sowohl bei einem schweißtechnischen Auftragen, als auch bei einem spritztechnischen Auftragen eines derartigen Schichtkörpers auf ein entsprechendes Einzelteil, zwischen dem Einzelteil und dem Schichtkörper ein Stoffschluß erzielt wird, der das Einzelteil in hohem Maße in jedem Falle mechanisch stabilisiert. Vorteilhaft ist ferner der äußerst geringe Aufwand an Herstellungswerkzeugen, zur Erzielung der angestrebten Erfordernisse.

Weitere Einzelheiten des vorliegenden Verfahrens, sowie Ausführungsbeispiele, die nach dem erfindungsgemäßen Verfahren hergestellt sind, sind in den Zeichnungen dargestellt und werden im folgenden näher erläutert. Es zeigen

Fig. 1 eine schaubildliche Ansicht eines Sockels für Stiluhren,
Fig. 2 eine schaubildliche Ansicht einer Platine einer Tastatur,
Fig. 3 eine schaubildliche Ansicht eines Baugruppenträgers,
Fig. 4 eine schaubildliche Ansicht einer Flüssigkristallanzeige,
Fig. 5 eine schaubildliche Ansicht eines Lichtleiterbandes,
Fig. 6 eine schaubildliche Ansicht eines Drehschalters,
Fig. 7 eine schaubildliche Ansicht einer Präzisionsantenne und
Fig. 8 eine schaubildliche Ansicht eines Ventilatorflügels

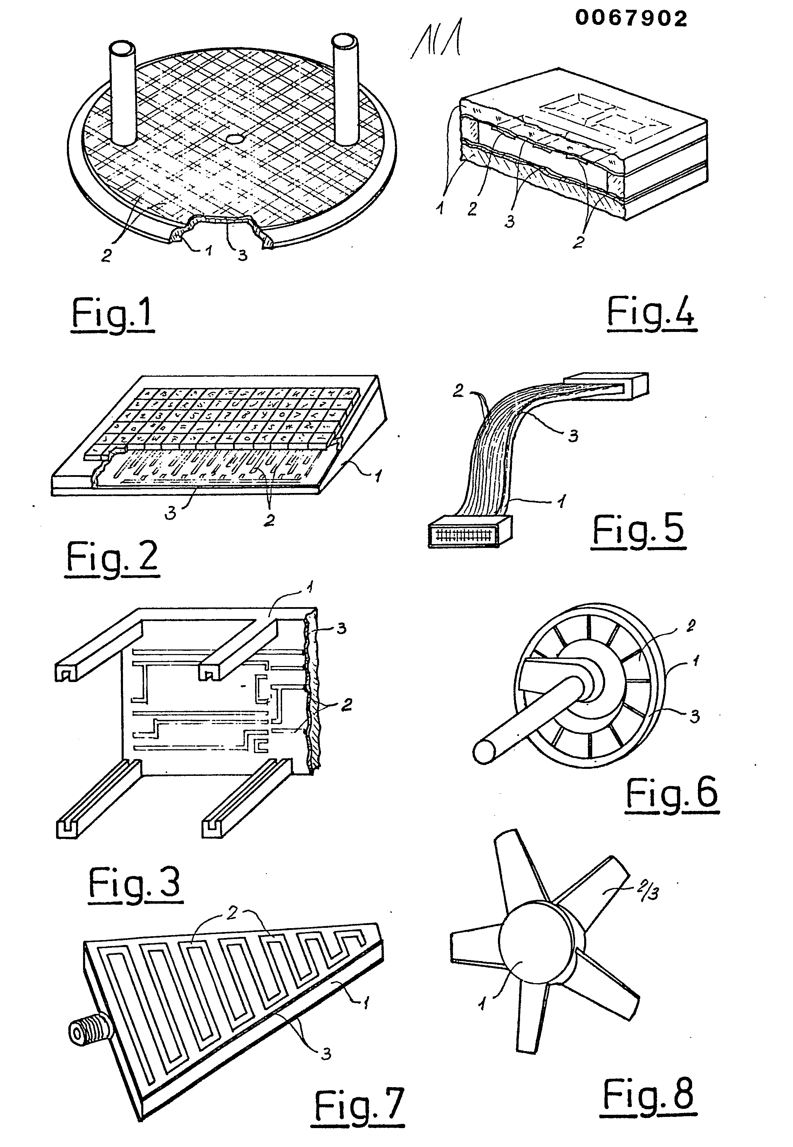

Bei Stiluhren ist es vielfach wünschenswert, die Gehäuse, insbesondere jedoch deren Sockel mit Verzierungen zu versehen. Diese Verzierungen sind dort häufig in die Sockeloberfläche eingearbeitet, insbesondere eingeäzt, eingedrückt oder eingraviert. Die Fig. 1 zeigt dort einen derartigen Sockel einer Stiluhr, insbesondere eine sogenannte Jahresuhr. Diese Sockel bestehen in der Regel aus einem sockelartigen Einzelteil aus einem Kunststoff, das mit einem entsprechend gezogenen metallenen Überzug versehen ist. Auf diesem Überzug sind dann die Verzierungen angeordnet. Sie sind dort, wie bereits zuvor erwähnt eingearbeitet. Dieses Verfahren ist außerordentlich aufwendig und teuer. Hier schafft das erfindungsgemäße Verfahren Abhilfe. Dies kann dort zweckmäßigerweise dadurch geschehen, daß die, auf das sockelartige Einzelteil 1 aus einem Kunststoff aufzutragenden Verzierungen in Form von Schichten 2 zunächst auf einen sogenannten Schichtkörper 3 aufgetragen und dort nichtlösbar angeordnet werden, und daß dann der fertig gestaltete Schichtkörper 3 mit den Schichten 2 auf dem Einzelteil 1 entsprechend räumlich angeordnet und mit dem Werkstoff des Einzelteiles 1, insbesondere stoffschlüssig verbunden, d.h. von diesem ummantelt wird.

Die Auftragung des fertigen Schichtkörpers 3 auf das Einzelteil kann dort nach einem, von mehreren möglichen, Verfahrensschritten dadurch erfolgen, daß der Schichtkörper 3 in das Spritzwerkzeug zur Herstellung des sockelartigen Einzelteiles 1 eingelegt wird, und daß dann der Kunststoff des Einzelteiles 1 den Schichtkörper 3 stoffschlüssig ummantelt.

Bei einem anderen möglichen Verfahrensschritt wird der fertige Schichtkörper 3 auf einem fertiggespritzten Einzelteil 1 entsprechend räumlich angeordnet und dann in einem sogenannten thermoplastischen Schweißverfahren, insbesondere mit Ultraschall, stoffschlüssig auf das Einzelteil 1 aufgetragen.

Vorteilhaft bei dieser Art der Herstellung derartiger Sockel ist nicht nur, daß dort die Verzierungen in Form von Schichten 2 zunächst relativ einfach und äußerst wirtschaftlich und präzise, insbesondere ätztechnisch in einen metallisch beschichteten Schichtkörper 3 eingearbeitet werden können, sondern daß durch die stoffschlüssige Ummantelung bzw. Verbindung des sockelartigen Einzelteiles 1 mit dem mit Schichten 2 versehenen Schichtkörper 3, insbesondere durch die metallnetzartigen Schichten 2 der Sockel mechanisch in hohem Maße stabilisiert wird.

Das erfindungsgemäße Verfahren beschränkt sich dort nicht nur auf die Herstellung von Sockeln, sondern ist natürlich ganz allgemein bei Gehäusen für Uhren anwendbar, sofern dort ein Grundkörper aus einem Kunststoff vorgesehen ist. Es ist natürlich auch möglich, nach dem vorliegenden Verfahren insbesondere Gläser für Uhren aus klarem Plexiglas (Schutzmarke) mit entsprechenden Verzierungen, insbesondere aus Schichten 2 aus metallischen Werkstoffen, wirtschaftlich sehr solide herzustellen. An Stelle von metallischen Schichten 2 auf einem Schichtkörper 3 können dort auch Verzierungen oder anderweitige Darstellungen in Schichten 2 aus Farbe oder einem anderen Stoff aufgedruckt, aufgeprägt, aufgespritzt oder filmtechnisch aufgetragen sein, die dann, gemäß dem Verfahren nach der Erfindung vom Werkstoff des Einzelteiles 1 teilweise, oder erforderlichenfalls allseitig, insbesondere stoffschlüssig ummantelt werden.

Ein anderes Beispiel für die sinnvolle, zweckmäßige und rationell/wirtschaftliche Anwendung des erfindungsgemäßen Verfahrens zeigt die Fig. 2 an einer beschichteten Platine eines sogenannten Keyboard's oder Tastatur. Im Einzelnen bedeutet dort 1 ein Einzelteil aus einem Kunststoff des rückseitigen Platinenteiles der Tastatur auf dem, in Form von Schichten 2 elektrische Leiterbahnen aufgetragen sind. Diese Leiterbahnen-Schichten 2 sind gemäß dem vorliegenden Verfahren zunächst auf einem Schichtkörper 3 nichtlösbar aufgetragen und angeordnet. Ein solcher fertiger Schichtkörper 3 wird dann mit dem Einzelteil 1, insbesondere stoffschlüssig, verbunden. Dieses Verbinden kann wiederum nach einem von mehreren möglichen Verfahrensschritten im Rahmen der Erfindung erfolgen. Dabei ist es besonders zweckmäßig, den fertigen Schichtkörper 3 in das Spritz-/Presswerkzeug zur Herstellung des Einzelteiles 1 einzulegen und vom Werkstoff des Einzelteiles 1 unmittelbar zu ummanteln. Auch bei dieser Anwendung stabilisieren die Schichten 2 das Einzelteil 1 mechanisch in hohem Maße.

Ein weiters, mit der Platine, nach Fig. 2, vergleichbares Beispiel zeigt die Fig. 3, mit einem Baugruppenträger, insbesondere für elektronische Datenverarbeitungsgeräte, Kleincomputer oder für elektronisches Spielzeug, in welchen bestückte Leiterplatten oder sonstige aktive oder passive Bauelemente oder Baugruppen gelagert und elektrisch leitend miteinander verbunden sind. Im Einzelnen besteht dort der Baugruppenträger aus einem Einzelteil 1 aus einem Kunststoff, das mit einer Vielzahl von Führungen 4 für die einzelnen Baugruppen versehen ist. Im Bereich dieser Führungen 4 sind Schichten 2 in Form von elektrisch oder optoelektronisch leitenden Verbindungen vorgesehen, zur Verbindung der einzelnen Baugruppen miteinander.

Diese elektrisch oder optoelektronisch leitenden Schichten 2 können nun zweckmäßigerweise vorteilhaft, äußerst präzise und wirtschaftlich nach dem vorliegenden Verfahren auf das Einzelteil 1 aufgetragen werden. Dabei werden die Schichten 2 zunächst auf einen Schichtkörper 3 aufgetragen, der dann im Rahmen des Spritz-/Pressverfahrens zur Herstellung des Einzelteiles 1 oder schweißtechnisch mit einem spritz-/presstechnisch fertigen Einzelteil 1, insbesondere stoffschlüssig ummantelt wird. Sowohl die elektrisch leitenden Schichten 2 in Form von metallenen Leiterbahnen, als auch die optoelektronisch leitenden Schichten 2 in Form Lichtleiterfasern, -bündeln oder -kabel können dort rationell, sehr genau und wirtschaftlich auf einen Schichtkörper 3 aus einer Kunststofffolie aufgetragen und gehandhabt werden.

Eine weitere zweckmäßige und vorteilhafte Anwendung des vorliegenden Verfahrens zeigt das Beispiel nach der Fig. 4, mit einer sogenannten Flüssigkristallanzeige. Wie dort der Aufbau einer derartigen Anzeige zeigt ist das vorderseitige Einzelteil 1 in Form eines Kunststoffglases innen mit einer Schicht 2 in Form von elektrisch leitenden Zinnoxydelektroden versehen. Auf der gegenüberliegenden Rückseite 5, die ebenfalls aus einem Kunststoff hergestellt sein kann, befindet sich innseitig ebenfalls eine Schicht 2 in Form einer Zinnoxydelektrode. Insbesondere die Elektroden-Schicht 2 auf dem vorderseitigen Einzelteil 1 muß hinreichend durchsichtig sein. Derartige Schichten 2 können nun wieder äußerst zweckmäßig und wirtschaftlich nach dem Verfahren gemäß der vorliegenden Erfindung sowohl auf das Einzelteil 1 als auch auf die dortige Rückseite 5 aufgebracht werden. Dies kann wiederum im Rahmen der Herstellung des Einzelteiles 1 und/ oder der Rückseite 5 in einem Spritz-/Pressverfahren oder schweißtechnisch, insbesondere ultraschweißtechnisch erfolgen. In jedem Falle werden die Schichten 2 zunächst wiederum auf einen Schichtkörper 3 aufgetragen, der dann auf ein entsprechendes Einzelteil 1 oder einen sonstigen Kunststoffteil übertragen, stoffschlüssig nichtlösbar angeordnet wird.

Diese spezielle Anwendung beschränkt sich nicht nur auf derartige Anzeigen, sondern kann insbesondere auf sogenannte Flachbildschirme ausgedehnt werden, wo insbesondere das vorderseitige, glasartige Einzelteil 1 mit matrixförmig verlaufenden Schichten 2 versehen ist. Insbesondere diese Schichten 2, die als Elektroden der Anzeige dienen, können äußerst zweckmäßig zunächst auf einen Schichtkörper 3 aufgetragen werden, wobei dann der fertige Schichtkörper 3 auf das glasklare Einzelteil 1 aus einem Kunststoff stoffschlüssig übertragen wird.

Die Fig. 5 zeigt ein weiters Anwendungsbeispiel des erfindungsgemäßen Verfahrens bei einem sogenannten optoelektronisch, lichtleitenden Adapter oder Lichtleiterbandes. Im Einzelnen bedeutet dort 1 ein, insbesondere flexibles Einzelteil aus einem Kunststoff, als Träger für die optoelektronisch leitenden Schichten 2, in Form von Lichtleiterfasern, die dort, gemäß dem vorliegenden Verfahren zunächst auf einem Schichtkörper 3 nichtlösbar angeordnet wurden, der dann stoffschlüssig auf das Einzelteil 1 übertragen wurde. Auch bei diesem Anwendungsfalle kann die Übertragung des Schichtkörpers 3 mit den Schichten 2 auf das Einzelteil 1 spritztechnisch, während der Herstellung des Einzelteiles 1, oder schweißtechnisch auf ein fertiges Einzelteil 1 erfolgen.

Die Fig. 6 zeigt einen elektrischen Drehschalter mit einer, insbesondere rückseitig vorgesehen Leiterbahn 6, bestehend aus einem Einzelteil 1 aus einem Kunststoff als Träger für die elektrisch leitenden Kontakte des Schalters in Form von Schichten 2, die auf dem Einzelteil 1 insbesodere winkelgenau angeordnet sein sollen. Die Auftragung dieser Schichten 2 auf das Einzelteil 1 kann wiederum nach dem vorliegenden Verfahren rationell und sehr genau erfolgen. Dabei werden die elektrisch leitenden Schichten zunächst wieder auf einen Schichtkörper 3 aufgetragen und der fertige Schichtkörper 3 wird dann wiederum stoffschlüssig mit dem Einzelteil 1 verbunden.

Die Fig. 7 zeigt eine spezielle Ausführung einer sogenannten Präzisionsantenne für den Mikrowellenbereich, die mit elektrisch leitenden Schichten 2 als aktive oder parasitäre Stahlerelemente versehen ist. 1 bezeichnet dort ein Einzelteil aus einem Kunststoff als Träger oder Isolator für die Strahlerelemente, die dort äußerst präzise angeordnet sein müssen.

Nach dem Verfahren, gemäß der vorliegenden Erfindung ist diese Erforderniss bei solchen Antennen rationell und wirtschaftlich erfüllbar. Die Strahlerelemente in Form der Schichten 2 werden dort zunächst wider auf einen Schichtkörper 3 aufgetragen, der dann, nach einem der zuvor bereits geschilderten Verfahrensschritte auf das Einzelteil 1 übertragen und mit diesem stoffschlüssig verbunden wird. Insbesondere für derartige Anwendungen bei Antennen, ist außerdem eine hohe mechanische Festigkeit und Beständigkeit erforderlich, die mit dem Verfahren hinreichend erzielt wird. Außerdem werden durch die sinnvolle Anwendung des vorliegenden Verfahrens relativ aufwendige Metallauftragungen, insbesondere nach galvanischen Verfahren überfüssig.

Eine weitere sinnvolle und zweckmäßige Anwendung des erfindungsgemäßen Verfahrens zeigt die Fig. 8. Dort soll ein Ventilatorflügel nicht nur mechanisch stabilisiert werden, sondern eine statische Aufladung derartiger Flügel aus Kunststoff soll hinreichend vermieden werden. Die bisherigen Herstellungsverfahren derartiger Flügel bedienten sich zur Erzielung der notwendigen mechanischen Stabilität mit Einlagen oder Einbettungen in den Kunststoff. Zur Vermeidung statischer Aufladungen wurden bestimmte, metallpulverhaltige Kunststoffe verwendet, die nicht nur sehr teurer sind sondern unter Umständen relativ unterschiedliche Widerstände bildeten, hinsichtlich der gesammten Flächenstruktur eines derartigen Flügels.

Das erfindungsgemäße Verfahren schafft auch hier vorteilhaft und wirtschaftlich Abhilfe, indem eine metallene Schicht 2 auf einem Schichtkörper 3 angeordnet stoffschlüssig auf das Einzelteil 1 des Flügels aus einem beliebigen Kunststoff aufgetragen wird. Dies kann insbesondere dadurch geschehen, daß der Schichtkörper 3 in das Spritz-/Presswerkzeug für den Flügel eingelegt wird und der Schichtkörper 3 vom Werkstoff des Einzelteiles 1 teilweise, oder erforderlichenfalls allseitig, insbesondere stoffschlüssig ummantelt wird. Damit ist eine hinreichende Abschirmung und damit statische Aufladung eines derartigen Flügels sichergestellt.

0067902

Das erfindungsgemäße Verfahren beschränkt sich nicht nur auf die zuvor geschilderten Anwendungsbeispiele, sondern ist ganz allgemein in der Feinwerktechnik, der Optik und der Elektrotechnik/Elektronik anwendbar.

Insbesondere überall dort, wo Einzelteile aus einem Kunststoff hergestellt mechanisch stabilisiert werden sollen, kann dieses Verfahren vorteilhaft eingesetzt werden. Derartige Einzelteile können nach diesem Verfahren quasi mit einer Laminierung versehen, verstärkt werden.

Von besonderem Vorteil ist die Anwendung dieses Verfahrens bei der Fertigung von Solarelementen auf voltascher Basis. Dort können die Siliziumschichten unmittelbar auf den Schichtkörper aufgetragen werden, der wiederum von einem Einzelteil aus einem Kunststoff ummantelt wird. Das Einzelteil kann dort ein Glaskörper sein, der die Solarelemente vorderseitig schützt. Insbesondere sind dort die Solarelemente d.h. der Schichtkörper insgesamt ummantelt

Patentansprüche

1. Verfahren zum Auftragen von mechanisch stabilisierenden und/oder elektrisch, oder optoelektronisch leitenden Schichten (2) auf Einzelteile (1) aus Kunststoffen, wobei diese Schichten (2), die insbesondere aus Folien, Filmen, Fäden, Geweben, oder Leiterbahnen aus metallischen oder nichtmetallischen Werkstoffen bestehen, nichtlösbar auf den Einzelteilen (1) aus Kunststoffen angeordnet sind, dadurch gekennzeichnet, daß die, auf ein Einzelteil (1) aus einem Kunststoff aufzutragenden Schichten (2), insbesondere in Form von strukturierten Folien oder Filmen, von Fäden oder Geweben, von elektrischen oder optoelektronischen Leiterbahnen, oder von Lichtleiterfasern oder -bündeln, zunächst auf einen sogenannten Schichtkörper (3) aufgetragen und dort nichtlösbar angeordnet sind, und daß der fertig gestaltete Schichtkörper (3) auf dem Einzelteil (1) aus einem Kunststoff, den Erfordernissen entsprechend räumlich angeordnet, vom Werkstoff des Einzelteiles (1) teilweise, oder erforderlichenfalls allseitig, insbesondere stoffschlüssig ummantelt ist.

2. Verfahren nach Patentanspruch 1, dadurch gekennzeichnet, daß der Schichtkörper (3) aus einer Kunststoffolie hergestellt ist, auf der die Schichten (2) angeordnet sind.

3. Verfahren nach Patentanspruch 1 und 2, dadurch gekennzeichnet, daß der Werkstoff des Schichtkörpers (3) mit denselben physikalischen und chemischen Eigenschaften versehen ist, wie der Werkstoff des Einzelteiles (1).

4. Verfahren nach Patentanspruch 1 bis 3, dadurch gekennzeichnet, daß die Schichten (2) durch Aufprägen, Aufdrucken, Aufspritzen, Aufdampfen, Aufgalvanisieren, Aufwalzen, Aufplatieren auf den Schichtkörper aufgetragen sind.

5. Verfahren nach Patentanspruch 1 bis 5, dadurch gekennzeichnet, daß auf dem Schichtkörper (3) Schichten (2) mit zueinander unterschiedlichen, metallischen oder nichtmetallischen, Werkstoffen vorgesehen sind.

6. Verfahren nach Patentanspruch 1 bis 5, dadurch gekennzeichnet, daß der Schichtkörper (3) in einem, insbesondere Ultraschallschweißverfahren auf das Einzelteil (1) stoffschlüssig aufgetragen, nichtlösbar befestigt ist.

7. Verfahren nach Patentanspruch 1 bis 5, dadurch gekennzeichnet, daß der Schichtkörper (3) in einem Spritzgußverfahren vom Werkstoff des Einzelteiles (1) teilweise, bis·auf die jeweilige, durch den Schichtkörper (3) gebildete Vorder- oder Rückseite eines Einzelteiles (1) stoffschlüssig ummantelt ist.

8. Verfahren nach Patentanspruch 1 bis 7, dadurch gekennzeichnet, daß ein Einzelteil (1) als Teil einer Uhr, oder eines Spielzeuges, oder eines Taschenrechners, oder eines Baugruppenträgers für elektronische oder elektrische Baugruppen, oder als Flüssigkristallscheibe, oder als Lichtleitadapter, oder als Tastaturträger, oder als Drehschalter, oder als Ventilatorflügel, oder als Mikrowellenantenne ausgebildet ist

0067902

Fig.1

Fig. 2

Fig.3

Fig.4

Fig.5

Fig.6

Fig.7

Fig.8

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | FR - A - 2 107 979 (PICTORIAL PRODUCTIONS) <br><br> * Seite 3, Zeile 33 - Seite 4, Zeile 14; Seite 4, Zeile 27 - Seite 5, Zeile 20; Seite 7, Zeilen 18-26; Seite 8, Zeile 5 - Seite 9, Zeile 30; Figuren 1-3 * <br><br> & DE - A - 2 147 510 | 1-8 |
| X | US - A - 3 668 034 (NICHOLAS et al) <br><br> * Spalte 1, Zeilen 6-40; Spalte 2, Zeilen 25-30 und Zeilen 68-70; Spalte 3, Zeilen 12-57; Figuren 1-3 * | 1-4,7 |
| Y | FR - A - 1 160 037 (REGIS PAPER COMPANY) <br><br> * Seite 1, linke Spalte, Zeilen 1-5 und rechte Spalte, Zeilen 7-21; Seite 2, linke Spalte, letzter Absatz - Seite 4, linke Spalte, Zeile 13; Figuren 1-7 * | 1,2,4 |
| Y | US - A - 3 915 780 (BROUSSARD et al) <br><br> * Spalte 2, Zeile 41 - Spalte 3, Zeile 41, Spalte 4, Zeilen 30-48; Figuren 1,2 * | 1,2 |
| A | US - A - 3 284 257 (SOLOFF et al) <br><br> * Spalte 2, Zeilen 34-54; Figur 1* | 6 |

**KLASSIFIKATION DER ANMELDUNG (Int. Cl.³)**

B 32 B 27/00
B 29 F 1/10
B 29 D 11/00

**RECHERCHIERTE SACHGEBIETE (Int. Cl.³)**

B 32 B
H 05 K

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

| Der vorliegende Recherchenbericht wurde für alle Patentansprüche erstellt. |
|---|

| Recherchenort | Abschlußdatum der Recherche | Prüfer |
|---|---|---|
| Den Haag | 09-03-1982 | LAVAL |

EPA form 1503.1 06.78